# EUROPEAN PATENT APPLICATION

(11) **EP 4 641 624 A1**
(43) Date of publication of application: **29.10.2025**
(21) Application number: 23906719.2
(22) Date of filing: 05.12.2023
(51) Int. Cl.: H01L 21/52, B23K 26/57

(54) **TRANSFER DEVICE**

(30) Priority: 23.12.2022 JP 2022207386
(71) Applicant: Toray Engineering Co., Ltd., Tokyo 103-0028 (JP)
(72) Inventor: EGAWA, Kohei, Otsu-shi, Shiga 520-0842 (JP); OKADA, Tatsuya, Otsu-shi, Shiga 520-0842 (JP); JINDA, Toshiyuki, Otsu-shi, Shiga 520-0842 (JP); KAZAMA, Koichi, Otsu-shi, Shiga 520-0842 (JP); FUJISHIGE, Haruka, Otsu-shi, Shiga 520-0842 (JP); ARAI, Yoshiyuki, Otsu-shi, Shiga 520-0842 (JP)
(74) Representative: Global IP Europe Patentanwaltskanzlei
(86) International application number: PCT/JP2023/043550
(87) International publication number: WO 2024/135353

(57) **Abstract**

To provide a transfer device that can prevent an excessive concentration of points irradiated with active energy rays. Specifically, provided is a transfer device 10 that irradiates a transfer substrate 22 with active energy rays 11 to transfer an element 21 held by the transfer substrate 22 onto a receiving substrate 23, the transfer device 10 comprising an energy emission unit 12 that intermittently emits active energy rays 11, and an irradiation position control unit 15 that controls the irradiation position of the active energy rays 11 emitted from the energy emission unit with 12 respect to the transfer substrate 22, wherein a time interval for the irradiation of the active energy rays onto the transfer substrate 22 is adjusted in accordance with the movement speed of the irradiation position of the active energy rays 11 on the transfer substrate 22, as controlled by the irradiation position control unit 15.

## Description

### [TECHNICAL FIELD]

The present invention relates to a transfer device that transfers an element to a receiving substrate by irradiating a transfer substrate with light energy.

### [BACKGROUND ART]

In recent years, semiconductor chips have been reduced in size for the purpose of cost reduction, and efforts are being made to mount such miniaturized semiconductor chips with high precision. A so-called laser lift-off method has been employed to mount such miniaturized chips at a high speed, in which laser is irradiated on a bonding surface of a chip bonded to a transfer substrate to cause ablation, which causes the chip to detach from the transfer substrate and be biased, thereby being transferred onto a receiving substrate.

Patent Document 1 discloses an element transfer device that uses the ablation technique to transfer an element. In this element transfer device, a laser irradiation device, having a laser light source for generating a laser beam, a reflection means for reflecting the laser beam from the laser light source in a required direction, and a control means for controlling irradiation and non-irradiation of the laser beam in conjunction with the reflection means, is used to selectively irradiate the laser beam on some of a plurality of elements arranged on a transfer substrate to cause ablation in a layer holding the elements. This selective ablation causes some of the elements to be transferred onto the receiving substrate. That is, the elements are transferred from the transfer substrate to the receiving substrate by laser lift-off.

### [PRIOR ART DOCUMENT]

### [PATENT DOCUMENTS]

[Patent Document 1]
Japanese Laid Open Patent Application Publication No. 2006-041500

### [SUMMARY OF THE INVENTION]

### [PROBLEM TO BE SOLVED BY THE INVENTION]

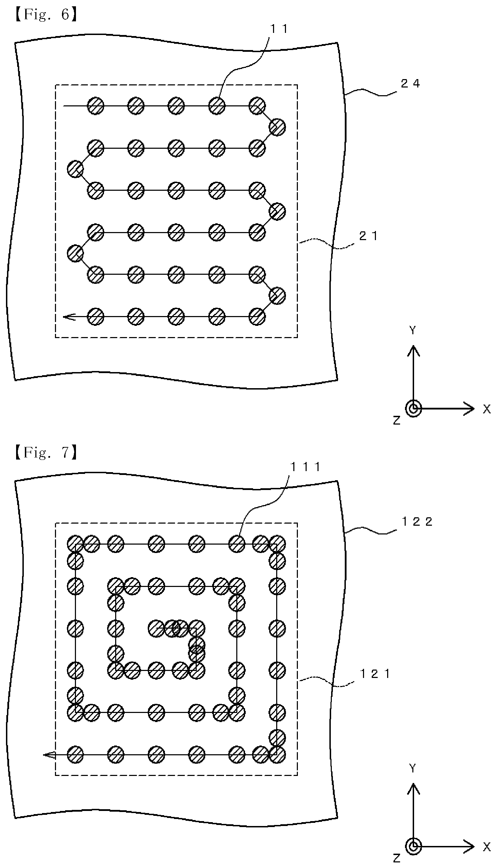

However, in the transfer device disclosed in Patent Document 1, in an accelerating/decelerating state, such as when the reflection means performs a turnaround action, there is the risk of generating, on the transfer substrate, a concentration of points that have been irradiated with the laser. In particular, there is the problem that, when irradiating, with a plurality of beams of laser light 111, a holding area of one element 121 on a transfer substrate 122 while changing the irradiation position to thereby transfer the element 121, as shown in Figure 7, the element 121 may become damaged at locations where there is a concentration of laser-irradiated points, which could generate cracks, etc., in the element 121.

In view of the problem described above, an object of the present invention is to provide a transfer device that can prevent an excessive concentration of points irradiated with active energy rays.

### [MEANS TO SOLVE THE PROBLEM]

In order to solve the problem described above, a transfer device of the present invention is a transfer device that irradiates a transfer substrate with active energy rays to transfer an element held by the transfer substrate onto a receiving substrate, the transfer device comprising an energy emission unit that intermittently emits active energy rays, and an irradiation position control unit that controls the irradiation position of the active energy rays emitted from the energy emission unit with respect to the transfer substrate, wherein a time interval for the irradiation of the active energy rays onto the transfer substrate is adjusted in accordance with the movement speed of the irradiation position of the active energy rays on the transfer substrate, as controlled by the irradiation position control unit.

According to the transfer device of the present invention, when the movement speed of the irradiation position of the active energy rays on the transfer substrate is relatively slow, such as when in an accelerating/decelerating state, the time interval for the irradiation of the active energy rays onto the transfer substrate is adjusted to be relatively long; it is thereby possible to prevent a concentration of points irradiated with the active energy rays.

It is also preferable that the time interval for the irradiation of the active energy rays onto the transfer substrate is adjusted to be relatively long when the movement direction of the irradiation position of the active energy rays is changed.

Since the movement speed of the irradiation position of the active energy rays decreases when the movement direction of the irradiation position of the active energy rays is changed, it is possible to prevent a concentration of points irradiated with the active energy rays in such cases.

In addition, the present invention is suitably used for transferring an element onto the receiving substrate by irradiating a holding area of one element held by the transfer substrate with active energy rays a plurality of times while changing the irradiation position.

Additionally, the time interval for the emission of the active energy rays by the energy emission unit can be adjusted, and it is preferable to adjust said emission time interval to adjust the time interval for the irradiation of the active energy rays onto the transfer substrate.

It is thereby possible to increase the time interval for the irradiation of the active energy rays onto the transfer substrate when in an accelerating/decelerating state.

In addition, it is preferable for the transfer device to further comprise an irradiation prevention unit that prevents the active energy rays emitted from the energy emission unit from being irradiated onto the transfer substrate, wherein the irradiation prevention unit is operated to prevent a portion of the active energy rays emitted from the energy emission unit from reaching the transfer substrate, thereby increasing the time interval for the irradiation of the active energy rays onto the transfer substrate.

Additionally, the irradiation prevention unit at this time is preferably an acousto-optic material.

It is thereby possible to increase the time interval for the irradiation of the active energy rays onto the transfer substrate when the movement speed of the irradiation position is relatively slow, even if the time interval for the emission of the active energy rays from the energy emission unit is constant.

### [EFFECTS OF THE INVENTION]

According to the transfer device of the present invention, it is possible to prevent an excessive concentration of points irradiated with active energy rays.

### [BRIEF DESCRIPTION OF THE DRAWINGS]

[Figure 1] is a diagram for explaining a transfer device according to one embodiment of the present invention.
[Figure 2] is a diagram showing a state of irradiation of laser light onto a transfer substrate by the transfer device shown in Figure 1.
[Figure 3] is an example of a data exchange modes of devices for forming the irradiation state shown in Figure 2.
[Figure 4] is a diagram for explaining a transfer device according to another embodiment of the present invention.
[Figure 5] is a diagram showing a state of irradiation of laser light onto a transfer substrate by the transfer device shown in Figure 4.
[Figure 6] is a diagram showing one example of a trajectory of irradiation spots of laser light.
[Figure 7] is a diagram showing a state of irradiation of laser light onto a transfer substrate by a conventional transfer device.

### [EMBODIMENTS TO CARRY OUT THE INVENTION]

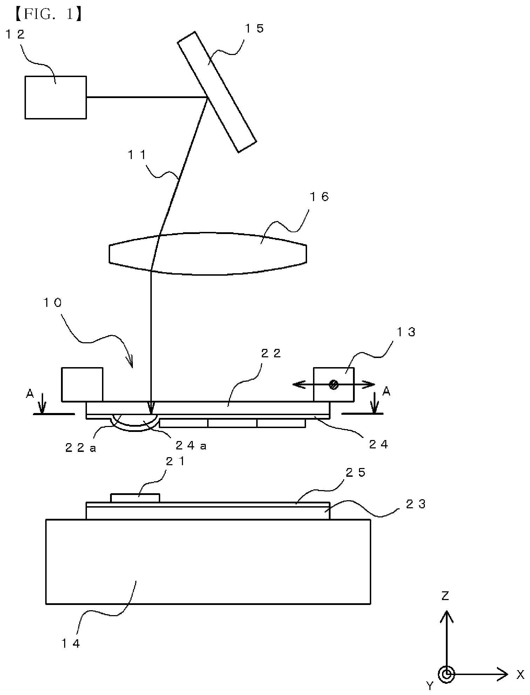

A transfer device according to one embodiment of the present invention will be described, with reference to Figure 1.

The transfer device 10 comprises a laser emission unit 12 that irradiates laser light 11, a transfer substrate holding unit 13 that can hold and move a transfer substrate 22 at least in an X-axis direction and a Y-axis direction, a receiving substrate holding unit 14 that is below the transfer substrate holding unit 13 and holds a receiving substrate 23 so as to face the transfer substrate 22 with a gap therebetween, and an undiagrammed control unit. The transfer device 10 irradiates the laser light 11 onto the transfer substrate 22 to cause ablation in the transfer substrate, thereby transferring an element 21 from the transfer substrate 22 to the receiving substrate 23.

The laser emission unit 12 is one embodiment of an energy emission unit in the present invention, is a device that intermittently emits the laser light 11, such as an excimer laser, which is an active energy ray, and is provided fixed to the transfer device 10. In the present embodiment, the laser emission unit 12 irradiates the spot-shaped laser light 11, the irradiation position of the laser light 11 in the X-axis direction and the Y-axis direction is controlled via an fθ lens 16 and a galvano mirror 15 whose angle is adjusted by a control unit, and the laser light 11 selectively irradiates a plurality of the elements 21 arranged on the transfer substrate 22 held by the transfer substrate holding unit 13. When the laser light 11 enters near the element 21 through the transfer substrate 22, ablation occurs between the transfer substrate 22 and the element 21 due to the application of active energy (light energy). This ablation biases the element 21, and the element 21 is transferred from the transfer substrate 22 to the receiving substrate 23. In this description, the element 21 is, for example, a semiconductor chip. In addition, a member that controls the irradiation position of the laser light 11, such as the galvano mirror 15, is also referred to as an irradiation position control unit in this description.

The transfer substrate holding unit 13 has an opening, and uses suction to hold the vicinity of the outer periphery of the transfer substrate 22. It is possible to irradiate the laser light 11 that is emitted from the laser emission unit 12 onto the transfer substrate 22, which is held by the transfer substrate holding unit 13, via this opening.

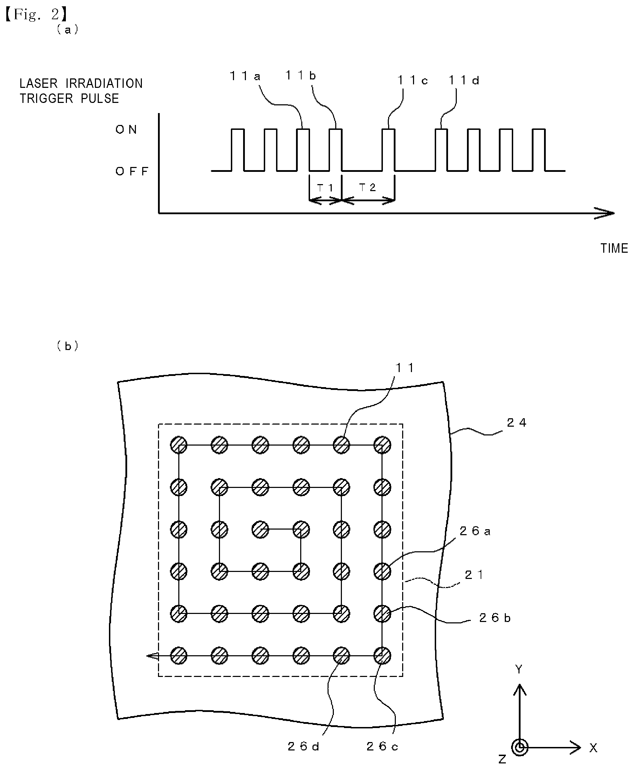

The transfer substrate 22 is a substrate made of glass, or the like, that can transmit the laser light 11, and that holds the element 21 on the bottom surface side thereof. In addition, a release layer 24 is formed on the surface of the transfer substrate 22 that holds the element 21, as shown in Figure 2(a), and the surface of this release layer 24 has adhesiveness. The adhesive force of this surface of the release layer 24 serves as the holding force for the element 21, thereby adhesively holding the element 21. In addition, when the laser light 11 is irradiated on the release layer 24, ablation occurs, and the release layer 24 is decomposed, is gasified, and disappears.

In addition, the transfer substrate holding unit 13 is moved, by an undiagrammed movement mechanism, relative to the receiving substrate holding unit 14 in at least the X-axis direction and the Y-axis direction. As a result of an undiagrammed control unit controlling this movement mechanism and adjusting the position of the transfer substrate holding unit 13, it is possible to adjust the relative position of the element 21 held by the transfer substrate 22 relative to the receiving substrate 23.

The receiving substrate holding unit 14 has a flat upper surface, and, during the transfer step of the element 21, holds the receiving substrate 24 such that the release layer 24 of the transfer substrate 23 and the element 21 held by the release layer 24 face the receiving surface of the receiving substrate 23. A plurality of suction holes are provided on the upper surface of the receiving substrate holding unit 14, and hold the rear surface of the receiving substrate 23 (the surface on which the element is not transferred) using suction force.

Here, the receiving substrate 23 in the present embodiment is a substrate made of glass, etc., and, as shown in Figure 2(a), a receiving surface (surface on the side that receives the element 21) is provided with a capture layer 25 having adhesiveness, which adhesively holds the element 21 that has been transferred from the transfer substrate 22.

In the present embodiment, only the transfer substrate holding unit 13 is moved in the X-axis direction and the Y-axis direction to move the transfer substrate holding unit 13 and the receiving substrate holding unit 14 relative to each other in the X and Y directions, but if the dimensions of the receiving substrate 23 are large and the entire surface of the receiving substrate 23 cannot be placed directly below the irradiation range of the laser light 11, the receiving substrate holding unit 14 may also be provided with a movement mechanism in the X-axis direction and the Y-axis direction.

In the transfer device 10 having the configuration described above, the laser light 11 is irradiated toward the element 21 through the transfer substrate 22 in a state in which the transfer substrate 22 and the receiving substrate 23 are facing each other across the element 21, and the laser light 11 is irradiated on the release layer 24; the energy of the laser light 11 thereby decomposes a part of the material of the release layer 24, generating gas. Then, when the material of the release layer 24 is decomposed to generate gas in the holding area of one of the elements 21 on the transfer substrate 22, a blister 24a is formed inside the release layer 24 or at the boundary of the release layer 24 and the transfer substrate 22. When the blister 24a is formed, the contact area between the element 21 and the surface of the release layer 24 decreases and at the same time the holding force of the release layer 24 on the element 21 decreases. As a result, the element 21separates from the transfer substrate 22 and moves to the receiving substrate 23. That is, laser lift-off is carried out.

Figure 2 shows a state of irradiation of laser light onto a transfer substrate by the transfer device of the present embodiment. Figure 2(a) shows the state of emission of laser light by the laser emission unit, and Figure 2(b) is a view in the arrow direction of the AA line in Figure 1, showing a state of irradiation of the laser light onto the transfer substrate.

In the present embodiment, as shown in Figure 2(b), the laser light 11 is irradiated a plurality of times while changing the irradiation position in an area (dashed line area in Figure 2(b)) in which one of the elements 21 is held in the release layer 24 provided on the transfer substrate 22, to thereby transfer the element 21 from the transfer substrate 22 to the receiving substrate 23. The changing of the irradiation position (hereinafter also referred to as irradiation spot) of the laser light 11 is carried out by the galvano mirror 15, which is the irradiation position control unit in the present embodiment, as described above.

At this time, the trajectory of the movement of the irradiation spot of the laser light 11 in the present embodiment follows a linear movement in the X-axis direction, a 90-degree turn in the movement direction, a linear movement in the Y-axis direction, and a 90-degree turn in the movement direction, which are repeated to form essentially a spiral shape, as shown in Figure 2(b).

Here, when controlling the irradiation position of the laser light 11 on the transfer substrate 22 (release layer 24) with the galvano mirror 15 such that the trajectory of the irradiation spot becomes such an essentially a spiral shape, it is possible to set a constant movement speed (referred to as speed V1) when the irradiation spot moves in a straight line. On the other hand, when the movement direction is changed, such as the 90-degree turn in the present embodiment, the movement speed of the irradiation spot undergoes deceleration from speed V1 and then acceleration to speed V1, resulting in a movement speed that is relatively slower than speed V1.

At this time, if the timing of irradiation of the laser light 11 onto the release layer 24 is constant, there will be a concentration of points that are actually irradiated with the laser light 11, as shown in Figure 7, so that it is possible that the laser light 11 will continue to be irradiated even after the release layer 24 disappears, thereby damaging the element 21.

In contrast, in the present invention, the time interval for the irradiation of the laser light 11 on the transfer substrate 22 is adjusted in accordance with the movement speed of the irradiation position of the laser light 11 on the transfer substrate 22, as controlled by the irradiation position control unit (galvano mirror 15). Specifically, in comparison with the irradiation time interval of the laser light 11 on the transfer substrate 22 when the movement speed of the irradiation position of the laser light 11 on the transfer substrate 22 is a prescribed speed V1 and is relatively fast, the irradiation time interval of the laser light 11 on the transfer substrate 22 is adjusted to be relatively long when the movement speed is relatively slow, such as during an accelerating/decelerating state until reaching this prescribed speed V1.

More specifically, in the present embodiment, the irradiation time interval of the laser light 11 (for example, the time interval between a trigger pulse (refer to Figure 2(a)) of laser light 11a to be irradiated onto a planned irradiation position 26a and a trigger pulse of laser light 11b to be irradiated onto a planned irradiation position 26b) in a state in which the irradiation spot moves linearly at the prescribed speed V1 in the example shown in Figure 2(b) is defined as time interval T1 shown in Figure 2(a).

In contrast, since the movement direction of the irradiation spot changes before and after irradiation of the laser light 11 onto planned irradiation position 26c, the movement speed of the irradiation spot undergoes deceleration from speed V1 and then acceleration to speed V1. Therefore, the time required for the irradiation spot to reach the planned irradiation position 26c from the planned irradiation position 26b, and the time required for the irradiation spot to reach planned irradiation position 26d from the planned irradiation position 26c, become longer than the time required for the irradiation spot to reach the planned irradiation position 26b from the planned irradiation position 26a. Accordingly, a time interval T2 between the trigger pulse of the laser light 11b irradiated onto the planned irradiation position 26b and the trigger pulse of laser light 11c irradiated onto the planned irradiation position 26c is set longer than the time interval T1. In addition, the time interval between the trigger pulse of the laser light 11c and the trigger pulse of laser light 11d irradiated onto the planned irradiation position 26d is also set to the time interval T2.

With the foregoing configuration, it is possible to prevent a concentration of points actually irradiated with the laser light 11 in areas where the movement speed accelerates and decelerates, such as where the movement direction of the irradiation spot changes. As a result, it is possible to prevent excessive energy from being locally applied by the laser light 11 to the release layer 24 and to the element 21.

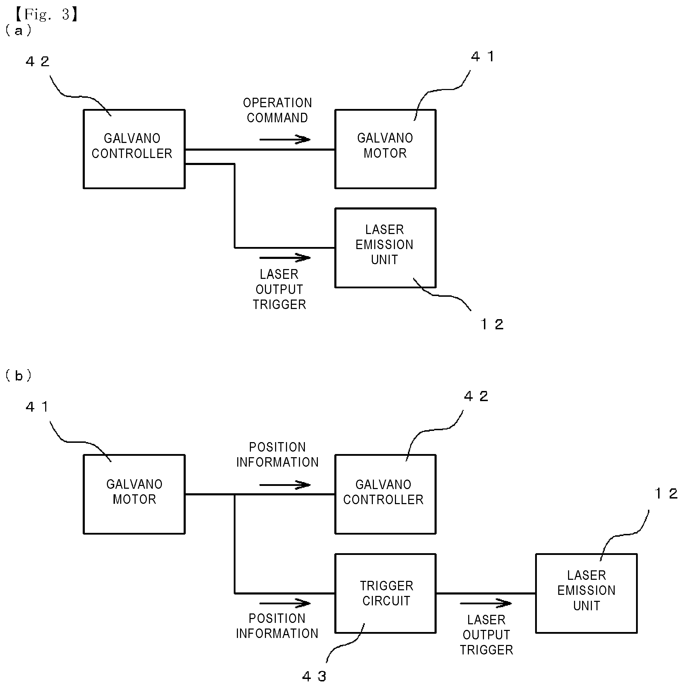

Figure 3(a) shows a data exchange mode and a configuration of devices for adjusting the irradiation time interval of the laser light 11, as described above.

In the present embodiment, a galvano motor 41 that adjusts the angle of the galvano mirror 15 and a galvano controller 42 that controls the operation of the galvano motor 41 are connected by wiring, and the galvano controller 42 and the laser emission unit 12 are connected by wiring.

In addition, data of a plurality of planned irradiation positions of the laser light 11 to be irradiated onto the release layer 24 in order to transfer one of the elements 21, and data of movement patterns of the irradiation spot, are stored in advance in an undiagrammed control unit; when the movement pattern data are input to the galvano controller 42, an operation command for realizing this movement pattern is issued from the galvano controller 42 to the galvano motor 41. Then, the galvano motor 41 is driven on the basis of this operation command and the angle of the galvano mirror 15 changes continuously, whereby the release layer 24 is irradiated with the laser light 11 in accordance with a prescribed movement pattern.

Here, the galvano controller 42 takes into consideration the speed, acceleration, and deceleration of the galvano motor 41 to calculate the arrival time of the laser light 11 to each planned irradiation position set in the above-mentioned movement pattern. In addition, in the present embodiment, the galvano controller 42 also serves as a trigger circuit that transmits, to the laser emission unit 12, trigger pulses for triggering emission (output) of the laser light 11. The galvano controller 42 transmits a trigger pulse to the laser emission unit 12 at each of the above-mentioned arrival times, thereby irradiating a given planned irradiation position on the release layer 24 with the laser light 11.

Here, the galvano controller 42 takes into consideration the acceleration/deceleration of the galvano motor 41 to calculate the arrival time to each planned irradiation position, as described above, so that it is possible to prevent an inadvertent concentration of points actually irradiated with the laser light 11 due to the acceleration/deceleration of the galvano motor 41.

The data of the plurality of planned irradiation positions of the laser light 11 and the data of the movement pattern of the irradiation spot described above may be manually created by an operator, or be automatically generated by an undiagrammed controller, using AI or the like. At this time, it is preferable to prepare parameters for the automatic generation, such as information on the shape of the element 21, information (energy, shape, etc.) on the laser light 11 emitted from the laser emission unit 12, and information on the energy required to ablate the release layer 24.

Here, the transfer device 10 may be capable of adjusting not only the time interval but also the output of the laser light 11 that is emitted. Then, by adjusting the output of the laser light 11 to be smaller when in the above-mentioned accelerating/decelerating state compared to when in other states, it is possible to further prevent an excessive amount of energy from being locally applied by the laser light 11.

Next, Figure 3(b) shows a data exchange mode and a configuration of devices according to another embodiment for adjusting the irradiation time interval of the laser light 11.

In the present embodiment, the galvano motor 41 is connected to the galvano controller 42 and a trigger circuit 43 by wiring. This trigger circuit 43 is for transmitting, to the laser emission unit 12, a trigger pulse that triggers emission (output) of the laser light 11, and is connected to the laser emission unit 12 by wiring.

In addition, data of a plurality of planned irradiation positions of the laser light 11 to be irradiated onto the release layer 24 in order to transfer one of the elements 21, and data of movement patterns of the irradiation spot of the laser light 11, are stored in advance in an undiagrammed control unit.

Then, position information of the galvano motor 41 is continuously transmitted from the galvano motor 41 to the galvano controller 42 and the trigger circuit 43. When the trigger circuit 43 confirms that the position information of the galvano motor 41 corresponds to a planned irradiation position of the laser light 11, the trigger circuit 43 transmits a trigger pulse to the laser emission unit 12, whereby each planned irradiation position provided on the release layer 24 is irradiated with the laser light 11.

In the case of this embodiment, since the trigger circuit 43 transmits a trigger pulse on the basis of the position information of the galvano motor 41, regardless of the arrival time to a prescribed planned irradiation position, the laser light 11 is emitted from the laser emission unit 12 when the irradiation spot reaches said planned irradiation position. Therefore, it is possible to irradiate a desired position with the laser light 11 regardless of the movement speed or the acceleration/deceleration of the irradiation spot, and, as a result, compared to the time interval for the irradiation of the laser light 11 on the transfer substrate 22 when the movement speed of the irradiation spot is a prescribed speed, the time interval for the irradiation of the laser light 11 on the transfer substrate 22 becomes longer during an accelerating/decelerating state until this prescribed speed is reached.

In addition, since the galvano controller 42 and the trigger circuit 43 are separately provided, the laser light 11 can be emitted from the laser emission unit 12 without stopping the operation of the galvano motor 41.

At this time, the trigger circuit 43 itself may convert the position information transmitted from the galvano motor 41 into speed information, thereby detecting the speed of the galvano motor 41, and adjust the emission time interval of the laser light 11 on the basis of the speed information of the galvano motor 41, as in the example of Figure 3(a).

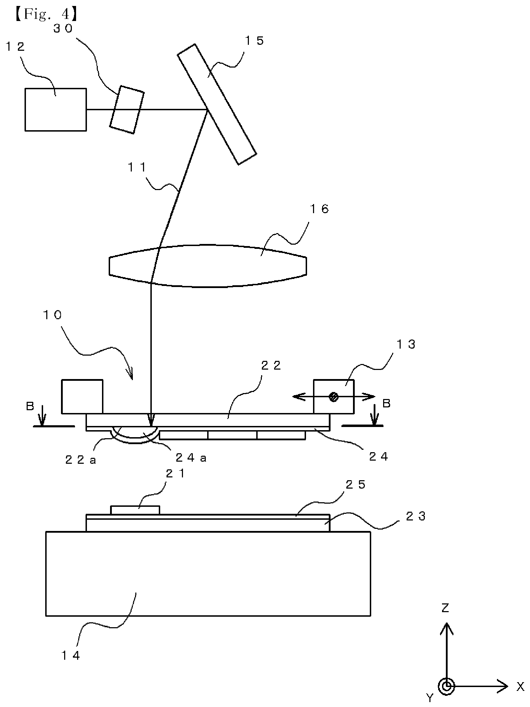

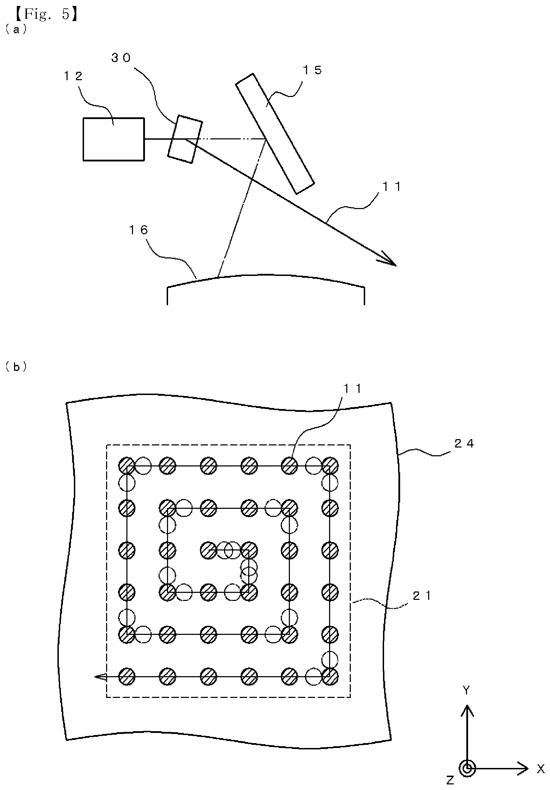

Next, a transfer device according to another embodiment of the present invention will be described with reference to Figures 4 and 5.

The transfer device 10 according to the present embodiment is different from the transfer device shown in Figure 1 in that an irradiation prevention unit 30 is provided on the path of the laser light 11 from the laser emission unit 12 to the galvano mirror 15.

When in operation, the irradiation prevention unit 30 is a member that prevents the laser light 11 emitted from the laser emission unit 12 from reaching the transfer substrate 22.

In the present embodiment, the irradiation prevention unit 30 is an acousto-optic material (AOM) which, when in operation, diffracts the laser light 11. The laser light 11 that is emitted from the laser emission unit 12 and diffracted by the operation of the acousto-optic material 30 travels along a path that does not hit the galvano mirror 15, as shown in Figure 5(a). Therefore, when the acousto-optic material 30 is operated, the laser light 11 emitted from the laser emission unit 12 is not irradiated on the transfer substrate 22 and is thinned out.

Figure 5(b) is a diagram showing a state of irradiation of laser light onto a transfer substrate by the transfer device of the present embodiment, and is a view in the arrow direction of the BB line in Figure 4.

In the present embodiment, differences in the time intervals of the emission of the laser light 11 from the laser emission unit 12, such as those shown in Figure 2, are not provided; rather, the laser light 11 is intermittently emitted at a regular time interval. As a result, when the galvano mirror 15 is in an accelerating/decelerating state and is moving at a relatively low speed, locations that would be irradiated with the laser light 11 are concentrated.

In such a case where the galvano mirror 15 is in an accelerating/decelerating state, the acousto-optic material 30 is operated to moderately suppress the laser light 11 emitted from the laser emission unit 12 that would otherwise reach the release layer 24, thereby preventing a concentration of points actually irradiated with the laser light 11 on the release layer 24.

In particular, since the emission time interval of the laser light 11 emitted from the laser emission unit 12 can be constant in the present embodiment, the emission of the laser light 11 becomes stable. As a result, it is possible to suppress the occurrence of so-called giant pulses.

According to the transfer device described above, it is possible to prevent an excessive concentration of points irradiated with active energy rays.

Here, the transfer device of the present invention is not limited to the embodiments described above, and may take other forms within the scope of the present invention. For example, in the foregoing description, laser light is irradiated a plurality of times onto one element while changing the irradiation position to transfer the element from the transfer substrate to the receiving substrate, but the invention is not limited thereto; the transfer device of the present invention may also be used in a case in which one element is transferred by irradiating laser light once.

In addition, in the foregoing description, the trajectory of the irradiation spot of the laser light is essentially spiral-shaped, but the invention is not limited thereto; for example, the trajectory may follow a linear movement in the positive X direction, a reversal in the movement direction after a shift in the negative Y direction, a linear movement in the negative X direction, and a reversal in the movement direction following a shift in the negative Y direction, which are repeated to form essentially a zigzag shape, as shown in Figure 6. In this case, the movement speed decelerates and accelerates when the movement direction of the irradiation spot is reversed; therefore, by setting the irradiation time interval of the laser light relatively long, in the same manner as in the above-mentioned embodiment, it is possible to avoid a concentration of points irradiated with the laser light.

In addition, in the foregoing description, blisters are formed inside the release layer of the transfer substrate by irradiation of laser light, resulting in the element being released, but the invention is not limited thereto; for example, the release layer may generate gas and disappear with the irradiation of the laser light.

In addition, in the foregoing description, the irradiation prevention unit is an acousto-optic material, but the invention is not limited thereto; the irradiation prevention unit may be a mirror, a shutter, or the like.

Additionally, as described above, the timings at which to make the irradiation time interval of the laser light relatively long are not necessarily limited to when the movement direction of the irradiation spot is changed.

### [DESCRIPTIONS OF THE REFERENCE SYMBOLS]

10 Transfer device
11 Laser light (active energy ray)
11a - 11d Laser light
12 Laser emission unit (energy emission unit)
13 Transfer substrate holding unit
14 Receiving substrate holding unit
15 Galvano mirror (irradiation position control unit)
16y Fθ lens
21 Element
22 Transfer substrate
22a Glass surface
23 Receiving substrate
24 Release layer
24a Blister
25 Capture layer
26a - d Planned irradiation positions
30 Acousto-optic material (irradiation prevention unit)
41 Galvano motor
42 Galvano controller
43 Trigger circuit
111 Laser light
121 Element
122 Transfer substrate

## Claims

1. A transfer device that irradiates a transfer substrate with active energy rays to transfer an element held by the transfer substrate to a receiving substrate, the transfer device comprising:
an energy emission unit that intermittently emits active energy rays, and
an irradiation position control unit that controls the irradiation position of the active energy rays emitted from the energy emission unit on the transfer substrate, wherein
a time interval for the irradiation of the active energy rays onto the transfer substrate is adjusted in accordance with the movement speed of the irradiation position of the active energy rays on the transfer substrate, as controlled by the irradiation position control unit.

2. The transfer device according to claim 1, wherein
when the movement direction of the irradiation position of active energy rays is changed, the time interval for the irradiation of the active energy rays onto the transfer substrate is adjusted to be relatively long.

3. The transfer device according to claim 1, wherein
a holding area of one element held by the transfer substrate is irradiated with active energy rays a plurality of times while changing the irradiation position to thereby transfer the element onto the receiving substrate.

4. The transfer device according to claim 1, wherein
a time interval for emission of active energy rays by the energy emission unit can be adjusted, and the emission time interval is adjusted to thereby adjust the time interval for the irradiation of the active energy rays onto the transfer substrate.

5. The transfer device according to claim 1, wherein
the transfer device further comprises an irradiation prevention unit that prevents active energy rays emitted from the energy emission unit from being irradiated onto the transfer substrate, and the irradiation prevention unit is operated to prevent a portion of the active energy rays emitted from the energy emission unit from reaching the transfer substrate, thereby increasing the time interval for the irradiation of the active energy rays onto the transfer substrate.

6. The transfer device according to claim 5, wherein the irradiation prevention unit is an acousto-optic material.
